## Europäisches Patentamt

## European Patent Office

## Office européen des brevets

(19)

(11) Veröffentlichungsnummer: **0 142 614**
**B1**

(12) **EUROPÄISCHE PATENTSCHRIFT**

(45) Veröffentlichungstag der Patentschrift:
04.11.87

(51) Int. Cl.⁴: **G 01 R 33/02,** G 01 R 33/06

(21) Anmeldenummer: **84108683.8**

(22) Anmeldetag: **23.07.84**

(54) **Schaltung mit Magnetfeldsensor zum Messen eines Magnetfeldes.**

(30) Priorität: **26.08.83 CH 4664/83**

(43) Veröffentlichungstag der Anmeldung:
**29.05.85 Patentblatt 85/22**

(45) Bekanntmachung des Hinweises auf die Patenterteilung:
**04.11.87 Patentblatt 87/45**

(84) Benannte Vertragsstaaten:
**AT BE DE FR GB IT NL SE**

(56) Entgegenhaltungen:
**GB-A-861 403**
**GB-A-1 251 553**
**US-A-3 267 368**

(73) Patentinhaber: **LGZ LANDIS & GYR ZUG AG, CH-6301 Zug (CH)**

(72) Erfinder: **Popovic, Radivoje, Friedbach 1, CH-6300 Zug (CH)**

(74) Vertreter: **Müller, Hans-Jürgen, Dipl.-Ing., Müller, Schupfner & Gauger Lucile-Grahn-Strasse 38 Postfach 80 13 69, D-8000 München 80 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

LIBER, STOCKHOLM 1987

## Beschreibung

### Anwendungsebiet und Zweck

Die Erfindung bezieht sich auf eine Schaltung mit Magnetfeldsensor zum Messen eines Magnetfeldes gemäss dem Oberbegriff des Anspruchs 1.

### Stand der Technik

Eine Vielzahl mehr oder weniger linearer Magnetfeldsensoren, wie z. B. Hallelemente, Magnetotransistoren, Magfet, Magnetodioden usw., sind aus vielen Literaturstellen bekannt. In der US-PS 4 100 563 z. B. wird ein Halbleiter-Magnetfeldsensor mit zwei Kollektor- und zwei Basis-Schichten beschrieben.

### Aufgabe und Lösung

Der Erfindung liegt die Aufgabe zugrunde, ohne grossen technischen Aufwand die Kennlinien der verschiedenen bekannten Magnetfeldsensoren zu linearisieren und gleichzeitig ihre Empfindlichkeit zu vergrössern, sowie temperaturunabhängig zu machen.

Die genannte Aufgabe wird erfindungsgemäss durch die im Kennzeichen des Anspruchs 1 angegebenen Merkmale gelöst.

Ein Ausführungsbeispiel der Erfindung ist in der Zeichnung dargestellt und wird im folgenden näher beschrieben.

Es zeigen:

Fig. 1 ein Blockschaltbild einer Schaltung mit Magnetfeldsensor zum Messen eines Magnetfeldes,

Fig. 2 ein elektrisches Schaltbild mit Bipolartransistoren des Magnetfeldsensors mit einem nachgeschalteten Verstärker,

Fig. 3 ein schematischer Querschnitt der räumlichen Anordnung des Magnetfeldsensors mit Bipolartransistoren und

Fig. 4 ein elektrisches Schaltbild mit MOS-Transistoren des Magnetfeldsensors.

Gleiche Bezugszahlen bezeichnen in allen Figuren der Zeichnung gleiche Teile.

### Beschreibung

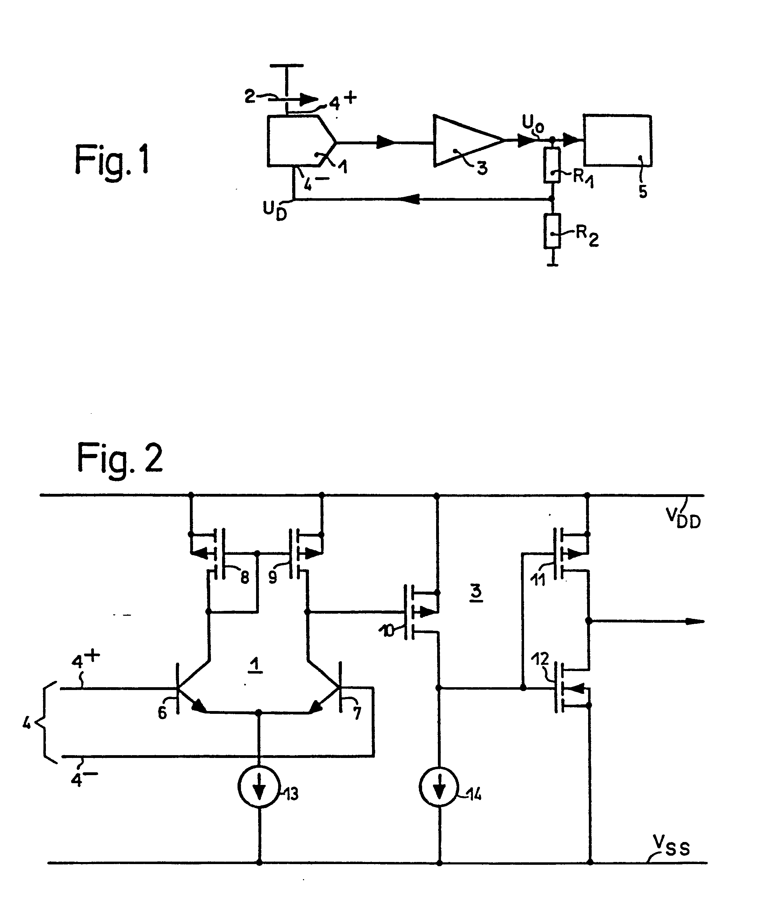

In den Figuren 1 bis 4 misst ein beliebiger Magnetfeldsensor 1 ein zu messendes Magnetfeld 2.

In der Fig. 1 ist der Ausgang des Magnetfeldsensors 1 mit dem Eingang des Verstärkers 3 und dessen Ausgang, der gleichzeitig den Ausgang eines linearen Magnetfeldsensors darstellt, mit dem Eingang eines aus Widerständen $R_1$ und $R_2$ bestehenden, mit einem Pol an Masse liegenden Spannungsteilers $R_{1;2}$ verbunden. Der gemeinsame Pol der beiden Widerstände $R_1$ und $R_2$ liegt an einem elektrischen Zusatzeingang 4 des Magnetfeldsensors 1.

Der Ausgang des linearen Magnetfeldsensors ist direkt mit dem Eingang einer Spannungs-Auswerteschaltung 5 verbunden. Ein innerhalb des Magnetfeldsensors 1 verstärktes Ausgangssignal des Spannungsteilers $R_{1;2}$ ist das Rückkopplungssignal des Magnetfeldsensors, und seine Wirkung ist im Magnetfeldsensor 1 entgegengesetzt der Wirkung des zu messenden Magnetfeldes 2.

Die Schaltung der Fig. 2 enthält z. B. einen ersten magnetfeldempfindlichen NPN-Bipolartrasistor 6, einen zweiten magnetfeldempfindlichen NPN-Bipolartransistor 7, einen ersten P-MOS Transistor 8, einen zweiten P-MOS Transistor 9, einen dritten P-MOS Transistor 10, einen vierten P-MOS Transistor 11, einen ersten N-MOS Transistor 12, eine erste N-Kanal Stromquelle 13 und eine zweite N-Kanal Stromquelle 14. Oie beiden Bipolartransistoren 6 und 7 bilden zusammen einen bekannten Magnetfeldsensor 1, wobei ihre beiden Basis-Anschlüsse zwei Zusatzeingänge 4 + und 4- bilden. Die beiden Emitter der Bipolartransistoren 6 und 7 sind miteinander und über die erste N-Kanal Stromquelle 13 mit dem negativen Pol $V_{SS}$ einer Speisespannung verbunden.

Die beiten P-MOS Transistoren 8 und 9 bilden zusammen eine bekannte Stromspiegel-Schaltung. Ihre Source- und Substrat-Anschlüsse sind alle auf den positiven Pol $V_{DD}$ der Speisespannung und ihre Drain-Anschlüsse auf je einen Kollektor-Anschluss der Bipolartransistoren 6 und 7 geführt. Ausserdem sind ihre Gate-Anschlüsse miteinander und mit dem Drain-Anschluss eines der beiden P-MOS Transistoren 8 bzw. 9 verbunden. In der Darstellung der Fig. 2 ist dies der Drain-Anschluss des ersten P-MOS Transistors 8. Der Kollektor-Anschluss des zweiten Bipolartransistors 7 bildet den Ausgang des Magnetfeldsensors 1 und liegt am Gate-Anschluss des dritten P-MOS Transistors 10, dessen Drain-Anschluss einerseits direkt mit den Gate-Anschlüssen des vierten P-MOS und des ersten N-MOS Transistors 11 und 12 und anderseits über die zweite N-Kanal Stromquelle 14 mit dem negativen Pol $V_{SS}$ der Speisespannung verbunden ist.

Die Source- und die Substrat-Anschlüsse des dritten und des vierten P-MOS Transistors 10 und 11 liegen am positiven Pol $V_{DD}$ und diejenigen des ersten N-MOS Transistors 12 am negativen Pol $V_{SS}$ der Speisespannung. Die beiden Drain-Anschlüsse des vierten P-MOS und des ersten N-MOS Transistors 11 und 12 sind miteinander und mit dem Ausgang des linearen Magnetfeldsensors verbunden.

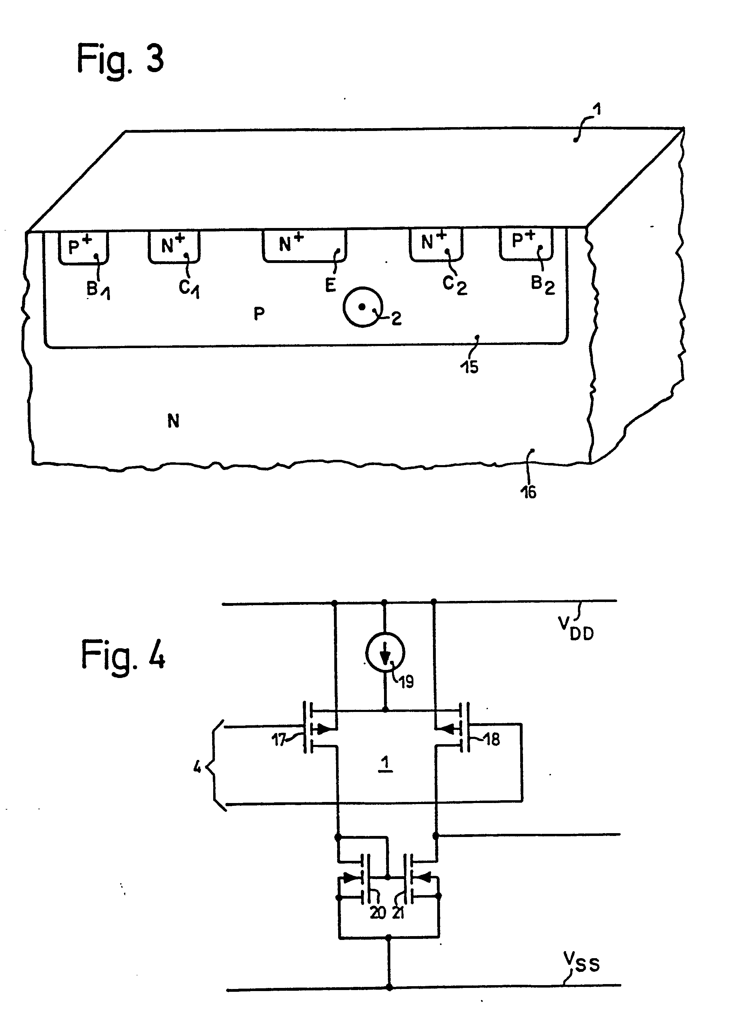

Der dritte und vierte P-MOS Transistor 10 und 11, sowie der erste N-MOS Transistor 12 bilden zusammen den Verstärker 3, wobei der dritte P-MOS Transistor 10 einen Vorverstärker und die beiden anderen Transistoren 11 und 12 einen CMOS-Ausgangsverstärker darstellen. Die beiden Bipolartransistoren 6 und 7 der Fig. 2 bestehen z. B. aus einem einzigen Ersatz-Transistor mit einer Emitter-, zwei Kollektor- und zwei Basis-Schichten, dessen räumlicher Aufbau innerhalb eines Halbleiter-Kristalls aus der Fig. 3 ersichtlich ist.

Eine Wanne 15 aus schwach mit Fremdatomen dotiertem P-Material ist in einem Substrat 16 aus ebenfalls schwach mit Fremdatomen dotiertem N-Material eindiffundiert. In der Wanne 15 sind ihrerseits nebeneinander in der angegeben Reihenfolge und in der Darstellung der Fig. 3 von links nach rechts eine erste Basis-Schicht B1, eine erste Kollektor-Schicht C1, eine einzige zentrale Emitter-Schicht E, eine zweite Kollektor-Schicht C2 und eine zweite Basis-Schicht B2 aus stark mit Fremdatomen dotiertem P+- bzw. N+-Material eindiffundiert. Die Schichten E, C1 und C2 bestehen gemäss der Fig. 3 aus N+-Material und die Basis-Schichten B1 und B2 aus P+-Material. Der Ersatz-Transistor bzw. der erste und zweite Bipolartransistor 6 und 7 stellen den magnetfeldempfindlichen Teil des Magnetfeldsensors 1 dar.

Der Magnetfeldsensor 1 kann auch mittels MOS-Transistoren aufgebaut werden statt mittels Bipolartransistoren. Ein derartiger Magnetfeldsensor 1 ist in der Fig. 4 dargestellt. Die beiden Gate-Anschlüsse eines fünften P-MOS Transistors 17 und eines sechsten P-MOS Transistors 16 bilden in der Fig. 4 den zweipoligen Zusatzeingang 4 des Magnetfeldsensors 1, während ihre Substrat-Anschlüsse direkt und ihre Source-Anschlüsse über eine gemeinsame P-Kanal Stromquelle 19 mit dem positiven Pol $V_{DD}$ der Speisespannung verbunden sind. Der fünfte und der sechste P-MOS Transistor 17 und 18, die zusammen einen Split-Drain Transistor bilden, stellen den magnetfeldempfindlichen Teil des Magnetfeldsensors 1 dar.

Ein zweiter N-MOS Transistor 20 und ein dritter N-MOS Transistor 21 bilden zusammen eine Stromspiegel-Schaltung. Ihre Substrat- und ihre Source-Anschlüsse liegen alle am negativen Pol $V_{SS}$ der Speisespannung, während ihre Drain-Anschlüsse mit je einem Drain-Anschluss des fünften bzw. sechsten P-MOS Transistors 17 und 18 verbunden sind. Die beiden Gate-Anschlüsse des zweiten und dritten N-MOS Transistors 20 und 21 sind miteinander und mit einem ihrer Drain-Anschlüsse verbunden, z. B. mit demjenigen des zweiten N-MOS Transistors 20. Der Drain-Anschluss des dritten N-MOS Transistors 21 bildet z. B. den Ausgang des Magnetfeldsensors 1. Statt der beiden N-MOS Transistoren 20 und 21 kann auch ein Split-Drain N-MOS Transistor als Ersatz-Transistor verwendet werden. Dieser besitzt zwei Drain- und zwei Gate-Anschlüsse.

Der erste und zweite Bipolartransistor 6 und 7 bzw. der fünfte und sechste P-MOS Transistor 17 und 18 oder ihre Ersatz-Transistoren sind als Differenzstufe geschaltet.

Der Magnetfeldsensor 1, die beiden Widerstände R1 und R2 sowie der Verstärker 3 werden am besten in einer einzigen integrierten Schaltung Integriert.

### Funktionsbeschreibung

Die Arbeitsweise des Magnetfeldsensors 1 ist an sich bekannt. Ein solcher Magnetfeldsensor 1 besitzt oft eine niedrige Empfindlichkeit, und diese ist oft nicht konstant, temperaturabhängig und von Bauelement zu Bauelement mit grossen Toleranzen behaftet. Um diese negative Faktoren zu minimieren, wird die Schaltung nach Fig. 1 verwendet.

Nachfolgend gelten folgende Bezeichnungen:
$H_2$ : Wert des zu messenden Magnetfeldes 2,
$K_H$ : Empfindlichkeit des Magnetfeldsensors 1 gegenüber Magnetfeldern,
$K_E$ : Empfindlichkeit des Magnetfeldsensors 1 gegenüber elektrischen Spannungen am Zusatzeingang 4,
$U_{In}$ : Eingansspannung des Verstärkers 3,
$K_V$ : Spannungs-Verstärkungsfaktor des Verstärkers 3,
$U_O$ : Ausgangsspannung des Verstärkers 3,
$K_D$ : Dämpfungsfaktor des Spannungsteilers $R_{1;2}$ mit $K_D = R2/(R1+R2)$ und
$U_D$ : Ausgangsspannung des Spannungsteilers $R_{1;2}$.
In der Fig. 1 gelten folgende Gleichungen:

$$(H_2 \cdot K_H - U_D \cdot K_E) = U_{In} \ (1),$$
$$U_D = K_D \cdot U_O \text{ und}$$
$$U_O = K_V \cdot U_{In}$$

Unter Berücksichtigung der beiden letzten Gleichungen, ergibt die Gleichung (1):

$$(H_2 \cdot K_H - K_D \cdot U_O \cdot K_E) = U_O/K_V \text{ oder}$$
$$H_2 \cdot K_H = (1/K_V + K_D \cdot K_E) \cdot U_O \text{ oder}$$
$$H_2 = (1 + K_V \cdot K_D \cdot K_E) \cdot U_O/(K_V \cdot K_H) \ (2)$$

Mit $K_V \cdot K_D \cdot K_E >> 1$, was leicht zu realisieren ist durch die Wahl eines Wertes $K_V >> 1$ für den Verstärker 3, wird Gleichung (2):

$$H_2 = (K_D \cdot K_E) \cdot U_O/K_H \ (3)$$

Da die Empfindlichkeiten des Magnetfeldsensors 1 gegenüber Magnetfeldern und gegenüber elektrischen Spannungen teilweise vom gleichen physikalischen Mechanismus abhängig sind, kann das Verhältnis $K_E/K_H$ in erster Näherung als konstant angesehen werden und z. B. mit $K_{tot}$ bezeichnet werden.

In diesem Fall reduziert sich Gleichung (3) auf:

$$H_2 = K_D \cdot K_{tot} \cdot U_O = K \cdot U_O \ (4)$$

d.h. die Ausgangsspannung $U_O$ des Verstärkers 3 ist proportional dem Wert $H_2$ des zu messenden Magnetfeldes 2 und der konstante Proportionalitätsfaktor ist $K = K_D \cdot K_{tot}$, der nur mehr abhängig ist von den Widerstandswerten R1 und R2 des Spannungsteilers $R_{1;2}$ und vom konstanten Wert $K_{tot}$.

$U_D \cdot K_E$ ist der Wert eines verstärkten Ausgangssignals des Spannungsteilers $R_{1;2}$. Wie aus der Gleichung (1) ersichtlich ist, ist im Magnetfeldsensor 1 die Differenz zwischen dem Wert des ebenfalls verstärkten zu messenden Magnetfeldes 2 und dem verstärkten Ausgangssignal des Spannungsteilers $R_{1;2}$ wirksam. Das letze Ausgangssignal ist das Rückkopplungssignal des Magnetfeldsensors 1.

Ist das Verhältnis $(K_E/K_H) = K_{tot}$ dagegen nicht konstant, sondern z. B. abhängig von einer Temperatur, so kann eine Temperaturkompensation zusätzlich eingebaut werden durch eine geeignete Wahl des Temperaturkoeffizienten $\theta_{R_1}$ und $\theta_{R_1}$ der beiden Widerstände R1 und R2 des Spannungsteilers $R_{1;2}$. Besitzt $K_{tot}$ nämlich einen bestimmten Temperaturkoeffizienten $\theta_{K_{tot}}$, so genügt es dem Dämpfungsfaktor $K_D$ einen Temperaturkoeff izienten $\theta_{K_D}$ mit einem umgekehrten Vorzeichen zu geben, der z. B. im Absolutwert gleich dem Temperaturkoeffizienten $\theta_{K_{tot}}$ des Verhältnisses $(K_E/K_H)$ ist, also $\theta_{K_D} = -\theta_{K_{tot}}$ zu wählen, damit der Proportionalitätsfaktor $K = K_D \cdot K_{tot}$ in der Gleichung (4) temperaturunabhängig wird, und der Wert des zu messenden Magnetfeldes 2 ideal proportional der Ausgangsspannung $U_O$ des Verstärkers 3 ist.

Der gewünschte Wert und das gewünschte Vorzeichen des Temperaturkoeffizienten $\theta_{K_D}$ des Dämpfungsfaktors $K_D = R2/(R1 + R2)$ wird erzielt z. B. durch eine geeignete Wahl von mindestens zwei unterschiedlichen Materialien zur Herstellung der beiden Widerstände R1 und R2, so dass der Temperaturkoeffizient $\theta_{R1}$ bzw. $\theta_{R2}$ eines der beiden Widerstände R1 bzw. R2 dominierend ist. Dies unter der Annahme, dass $R1 >> R2$ und somit $K_D \sim R2/R1$. Wird z. B. ein negativer Wert des Temperaturkoeffizienten $\theta_{K_D}$ benötigt, so wird der zweite Widerstand R2 im Falle der Figur 4 am besten aus einer stark mit Fremdatomen dotierten "Source" bzw. "Drain"- Schicht realisiert, und der erste Widerstand R1 am besten aus einer schwach mit Fremdatomen dotierten Wannen-Diffusionsschicht. In diesem Fall besitzt der zweite Widerstand R2 einen sehr niedrigen positiven Temperaturkoeffizienten $\theta_{R2}$ und der ersten Widerstand R1 eine hohen positiven Temperaturkoeffizienten $\theta_{R1}$. Der letzte Temperaturkoeffizient ist somit dominierend und der Dämpfungsfaktor $K_D$ besitzt, da der erste Widerstand R1 im Nenner von $K_D = R2/R1$ steht, einen negativen Wert.

Eine andere Realisierungs-Möglichkeit für die beiden Widerstände R1 und R2 besteht z. B. darin, die Widerstände aus unterschiedlichen Materialien auf die Oberfläche des Halbleiters aufzutragen, z. B. aufzudampfen.

Auf jeden Fall sollten die beiden Widerstände R1 und R2 und der magnetfeldempfindliche Eingangsteil des Magnetfeldsensors 1 möglichst Teil einer gleichen monolitischen integrierten Schaltung und möglichst nahe beieinander angeordnet sein, damit sie alle die gleiche Temperatur annehmen.

Die in den Figuren 1 bis 4 dargestellten Schaltungen werden z. B. in einem Elektrizitätszähler eingesetzt zur Messung des durch einen zu messenden Verbrauchstromes erzeugten Magnetfeldes 2.

**Patentansprüche**

1. Schaltung mit Magnetfeldsensor zum Messen eines Magnetfeldes, bei der der Ausgang des Magnetfeldsensors über einen Verstärker auf den Eingang des Magnetfeldsensors in der Weise rückgekoppelt ist, dass die Differenz zwischen dem möglicherweise verstärkten zu messenden Magnetfeld und einem Rückkopplungssignal im Magnetfeldsensor wirksam ist, dadurch gekennzeichnet, dass der Ausgang des Verstärkers (3) mit dem Eingang eines Spannungsteilers $(R_{1;2})$ verbunden ist, dessen Ausgang mit einem Zusatzeingang (4) des Mangnetfeldsensors (1) verbunden ist, wobei ein verstärktes Ausgangssignal des Spannungsteilers $(R_{1;2})$ das Rückkopplungssignal darstellt, und dass das Produkt aus der Empfindlichkeit $(K_E)$ des Magnetfeldsensors (1) gegenüber elektrischen Spannungen an seinem Zusats eingang (4), dem Spannungs-Verstärkungsfaktor $(K_V)$ des Verstärkers (3) und dem Dämpfungsfaktor $(K_D)$ des Spannungsteilers $(R_{1;2})$ viel grösser als Eins ist.

2. Schaltung nach Anspruch 1, dadurch gekennzeichnet, dass der Dämpfungsfaktor $(K_D)$ des Spannungsteilers $(R_{1;2})$ einen Temperaturkoeffizienten $(\theta_{K_D})$ besitzt, dessen Vorzeichnen umgekehrt demjenigen ist des Verhältnisses $(K_E/K_H)$ der Empfindlichkeit $(K_E)$ des Magnetfeldsensors (1) gegenüber elektrischen Spannungen und der Empfindlichkeit $(K_H)$ des Magnetfeldsensors (1) gegenüber Magnetfeldern.

3. Schaltung nach Anspruch 2, dadurch gekennzeichnet, dass ein erster Widerstand (R1) des Spannungsteilers $(R_{1;2})$ viel grösser ist als der andere zweite Widerstand (R2), und dass beide Widerstände (R1, R2) aus mindestens zwei unterschiedlichen Materialien bestehen, sodass der Temperaturkoeffizent $(\theta_{R1}$ bzw. $\theta_{R2})$ des einen Widerstandes (R1 bzw. R2) dominierend ist.

4. Schaltung nach Anspruch 2 oder 3, dadurch gekennzeichnet, dass die Temperaturkoeffizienten $(\theta_{K_D}, \theta_{K_{tot}})$ des Dämpfungsfaktors $(K_D)$ und des Verhältnisses $(K_E/K_H)$ einen gleichen Absolutwert besitzen.

5. Schaltung nach einem der Ansprüche 1 bis 4, dadurch gekennzeichnet, dass der Magnetfeldsensor (1) zwei Transistoren enthält, die als Differenzstufe geschaltet sind, wobei der Basis- bzw. der Gate-Anschluss eines jeden der beiden Transistoren (6, 7 bzw. 17, 18) einen Pol des Zusatzeinganges (4) des Magnetfeldsensors (1) darstellt.

6. Schaltung nach einem der Ansprüche 1 bis 4, dadurch gekennzeichnet, dass der Magnetfeldsensor (1) einen Transistor mit einer Emitter-, zwei Kollektor- und zwei Basis-Schichten enthält, der als Differenzstufe geschaltet ist, wobei die beiden Basis-Schichten je einen Pol des Zusatzeinganges (4) des Magnetfeldsensors (1) darstellen.

7. Schaltung nach einem der Ansprüche 1 bis 4, dadurch gekennzeichnet, dass der Magnetfeldsensor (1) einen Split-Drain Transistor enthält, der als Differenzstufe geschaltet ist, wobei seine beiden Gate-Anschlüsse je einen Pol des Zusatzeinganges (4) des Magnetfeldsensors (1) darstellen.

8. Schaltung nach einem der Ansprüche 1 bis 7, dadurch gekennzeichnet, dass sie ein Teil eines Elektrizitätszählers ist und zur Messung des durch einen zu messenden Strom erzeugten Magnetfeldes wirksam ist.

**Claims**

1. A circuit with a magnetic field sensor for measuring a magnetic field, in which the output of the magnetic field sensor is fed back by way of an amplifier to the input of the magnetic field sensor in such a way that the difference between the possibly amplified magnetic field to be measured and a feedback signal is effective in the magnetic field sensor, characterised in that the output of the amplifier (3) is connected to the input of a voltage divider $(R_{1;2})$ whose output is connected to an additional input (4) of the magnetic field sensor (1), an amplified output signal of the voltage divider $(R_{1;2})$ representing the feedback signal, and that the product of the sensitivity $(K_E)$ of the magnetic field sensor (1) in relation to electrical voltages at its additional input (4), the voltage gain factor $(K_V)$ of the amplifier (3) and the attenuation factor $(K_D)$ of the voltage divider $(R_{1;2})$ is much greater than one.

2. A circuit according to claim 1 characterised in that the attenuation factor $(K_D)$ of the voltage divider $(R_{1;2})$ has a temperature coefficient $(\theta_{K_D})$ whose sign is the inverse of that of the ratio $(K_E/K_H)$ of the sensitivity $(K_E)$ of the magnetic field sensor (1) in relation to electrial voltages and the sensitivity $(K_H)$ of the magnetic field sensor (1) in relation to magnetic fields.

3. A circuit according to claim 2 characterised in that a first resistor (R1) of the voltage divider $(R_{1;2})$ is much greater than the other second resistor (R2) and that both resistors (R1, R2) comprise at least two different materials so that the temperature coefficient $(\theta_{R1}$ and $\theta_{R2})$ of the one resistor (R1 and R2 respectively) is dominant.

4. A circuit according to claim 2 or claim 3 characterised in that the temperature coefficients $(\theta_{K_D}, \theta_{K_{tot}})$ of the attenuation factor $(K_D)$ and the ratio $(K_E/K_H)$ are of an equal absolute value.

5. A circuit according to one of claims 1 to 4 characterised in that the magnetic field sensor (1) includes two transistors which are connected as a difference stage, wherein the base and the gate teiminal respectively of each of the two transistors (6, 7 and 17, 18 respectively) represents a pole of the additional input (4) of the magnetic field sensor (1).

6. A circuit according to one of claims 1 to 4 characterised in that the magnetic field sensor (1) includes a transistor with an emitter layer, two collector layers and two base layers and which is connected as a difference stage, wherein the two base layers represent respective poles of the additional input (4) of the magnetic field sensor (1).

7. A circuit according to one of claims 1 to 4 characterised in that the magnetic field sensor (1) includes a split drain transistor which is connected as a difference stage, wherein its two gate terminals represent respective poles of the additional input (4) of the magnetic field sensor (1).

8. A circuit according to one of claims 1 to 7 characterised in that it is a part of an electricity meter and is operative for measuring the magnetic field generated by a current to be measured.

**Revendications**

1. Circuit comportant un détecteur de champ magnétique pour la mesure d'un champ magnétique, dans lequel la sortie du détecteur de champ magnétique est accouplée par réaction, par l'intermédiaire d'un amplificateur, à l'entrée du détecteur de champ magnétique de telle sorte que la différence entre le champ magnétique devant être mesuré, éventuellement amplifié, et un signal renvoyé par réaction est active dans le détecteur de champ magnétique, caractérisé en ce que la sortie de l'amplificateur (3) est reliée à l'entrée d'un diviseur de tension $(R_{1;2})$, dont la sortie est reliée à une entrée additionnelle (4) du détecteur de champ magnétique (1), un signal de sortie amplifié du diviseur de tension $(R_{1;2})$ représentant le signal renvoyé par réaction, et que le produit de la sensibilité $(K_E)$ du détecteur de champ magnétique (1) vis-à-vis de tensions électriques appliquées à son entrée supplémentaire (4), par le facteur d'amplification de tension $(K_V)$ de l'amplificateur (3) et par le facteur d'affaiblissement $(K_V)$ du diviseur de tension $(R_{1;2})$ est nettement supérieur à un.

2. Circuit selon la revendication 1, caractérisé en ce que le facteur d'affaiblissement $(K_D)$ du diviseur de tension $(R_{1;2})$ possède un coefficient de température $(\theta_{K_D})$, dont le signe est l'opposé de celui du rapport $(K_E/K_H)$ de la sensibilité $(K_E)$ du détecteur de champ magnétique (1) vis-à-vis de tensions électriques à la sensibilité $(K_H)$ du détecteur de champ magnétique (1) vis-à-vis de champs magnétiques.

3. Circuit selon la revendication 2, caractérisé en ce qu'une première résistance (R1) du diviseur de tension ($R_{1;2}$) est nettement supérieure à l'autre seconde résistance (R2), et que les deux résistances (R1, R2) sont constituées par au moins deux matériaux différents, de telle sorte que le coefficient de température ($\theta_{R1}$ ou $\theta_{R2}$) d'une résistance (R1 ou R2) est dominant.

4. Circuit selon la revendication 2 ou 3, caractérisé en ce que les coefficients de température ($\theta_{K_D}$, $\theta_{K_{tot}}$) du facteur d'affaiblissement ($K_D$) et du rapport ($K_E/K_H$) possédent des valeurs absolues identiques.

5. Circuit selon l'une des revendications 1 à 4, caractérisé en ce que le détecteur de champ magnétique (1) contient deux transistors, qui sont branchés sous la forme d'un étage différentiel, la borne de base ou la borne de grille de chacun des deux transistors (6, 7 ou 17, 18) représentant un pôle de l'entrée supplémentaire (4) du détecteur de champ magnétique (1).

6. Circuit selon l'une des revendications 1 à 4, caractérisé en ce que le détecteur de champ magnétique (1) contient un transistor possédant une couche d'émetteur, deux couches de collecteur et deux couches de base, et qui est branché en tant qu'étage différentiel, les deux couches de base représentant chacune un pôle de l'entrée supplémentaire (4) du détecteur de champ magnétique (1).

7. Circuit selon l'une des revendications 1 à 4, caractérisé en ce que le détecteur de champ magnétique (1) contient un transistor à drain subdivisé, qui est branché en tant qu'étage différentiel, les deux bornes de grille du transistor représentant chacune un pôle de l'entrée supplémentaire (4) du détecteur de champ magnétique (1).

8. Circuit selon l'une des revendications 1 à 7, caractérisé en ce qu'il fait partie d'un compteur d'électricité et est actif pour la mesure du champ magnétique produit par un courant à mesurer.

Fig. 1

Fig. 2

# Fig. 3

P$^+$  N$^+$  N$^+$  N$^+$  P$^+$

B$_1$  C$_1$  E  C$_2$  B$_2$

P

2

15

N

16

# Fig. 4

V$_{DD}$

19

17  1  18

4

20 21

V$_{SS}$

3